Europäisches Patentamt

European Patent Office

Office européen des brevets

(19)

(11) EP 1 054 311 B1

(12) EUROPEAN PATENT SPECIFICATION

(45) Date of publication and mention
of the grant of the patent:
**06.08.2003 Bulletin 2003/32**

(51) Int Cl.$^7$: **G05D 7/01**, H01J 37/32

(21) Application number: **00304190.2**

(22) Date of filing: **18.05.2000**

(54) **Gas delivery metering tube**

Dosierrohr für Gasabgabe

Tube doseur pour la fourniture de gaz

(84) Designated Contracting States:
**DE FR GB IT NL**

(30) Priority: **21.05.1999 US 135358**
**22.12.1999 US 470446**

(43) Date of publication of application:
**22.11.2000 Bulletin 2000/47**

(73) Proprietor: **ASML US, Inc.**
**Scott Valley, California 95066 (US)**

(72) Inventors:
• **Ingle, Nitin**
**Campbell, California 95008 (US)**
• **Young, Lydia J.**
**Palo Alto, California 94303 (US)**
• **Stoddard, D. Neil**
**Santa Cruz, California 95062 (US)**
• **DeSa, Anthony**
**Anaheim, California 92802 (US)**
• **Yao, Jack**
**Scotts Valley, California 95066 (US)**
• **Hamilton, Shawn**
**Felton, California 95018 (US)**

(74) Representative: **Stoner, Gerard Patrick et al**
**MEWBURN ELLIS**
**York House**
**23 Kingsway**
**London WC2B 6HP (GB)**

(56) References cited:
**US-A- 4 834 020** **US-A- 5 423 936**

• **PATENT ABSTRACTS OF JAPAN vol. 010, no. 194 (C-358), 8 July 1986 (1986-07-08) -& JP 61 037969 A (CANON INC), 22 February 1986 (1986-02-22)**

**EP 1 054 311 B1**

**Description**

This invention relates generally to a gas delivery metering tube for the delivery of gases. More particularly, the invention relates to nested axially aligned or co-axial gas delivery metering tubes that promote substantially uniform distribution of gases.

The delivery of gases is an important aspect in a great variety of industries. For example, in the field of semiconductor processing or manufacturing, the delivery of gases plays a critical role. One type of semiconductor processing is chemical vapor deposition. Chemical vapor deposition occurs when a stable compound is formed by a thermal reaction or decomposition of certain gaseous chemicals and such compounds are deposited on a surface of substrate. Chemical vapor deposition systems come in many forms. One apparatus for such a process comprises a conveyorized atmospheric pressure CVD (APCVD) system which is described in U.S. Patent 4,834,020 and is owned by assignee, and is incorporated herein by reference. Other types of CVD apparatus may be used, such as plasma-enhanced CVD (PECVD) systems, and low pressure CVD (LPCVD) systems.

Important components of a semiconductor processing system include a deposition chamber where deposition occurs, and the injector utilized for delivering gaseous chemicals to the surface of the substrate in the deposition chamber. The gases must be distributed over the substrate, so that the gases react and deposit an acceptable film at the surface of the substrate. The deposition chamber must be carefully designed to provide a controlled environment in which deposition can take place. For example, the chamber must provide gas confinement, but reduce recirculation of the gases which can cause pre reaction of the gases and the deposition of a non-uniform film. The chamber must provide exhaust means for the elimination of excess reactants and reaction by-products, yet not disrupt the flow of gases to the substrate for reaction. Moreover, the temperature of the chamber and its components must be carefully controlled to avoid condensation of reactant gases, minimize accumulation of byproduct dust, and enable cleaning of the system. Additionally, the deposition chamber should preferably maintain mechanical integrity (such as tolerances) throughout its operation. All of these factors must be carefully balanced to provide a proper environment for deposition.

A function of the injector in such a deposition chamber is to distribute the gases to a desired location in a controlled manner. Controlled distribution of the gases maximizes the chance of efficient, homogeneous gas phase reactions to produce the right kind of chemical species that will result in a high quality film on the substrate. Controlled gas distribution is needed to make sure the entire film is of a uniform composition. reaction of the gases, in part by minimizing pre-mixing and prior reaction of the gases. A complete reaction provides a greater opportunity for a good quality film. If the gas flow is uncontrolled, the chemical reaction will not be optimal and the result will likely be a film which is not of uniform composition. When the film is not of uniform composition, proper functioning of the semiconductor is impaired. Thus, it is important that an injector design facilitates the desired flow of the gases in a controlled manner.

Gases may be distributed in other areas of the chamber and/or by components in addition to the injector. For example, inert gases may be conveyed to the chamber to separate and/or direct deposition gases in a desired manner. Inert and other gases may be delivered to the chamber to function as dilution and carrier gases. One such example of the use of gases in such a manner is found in co-pending US patent application Serial Number 09/185,180, the entire disclosure of which is hereby incorporated by reference.

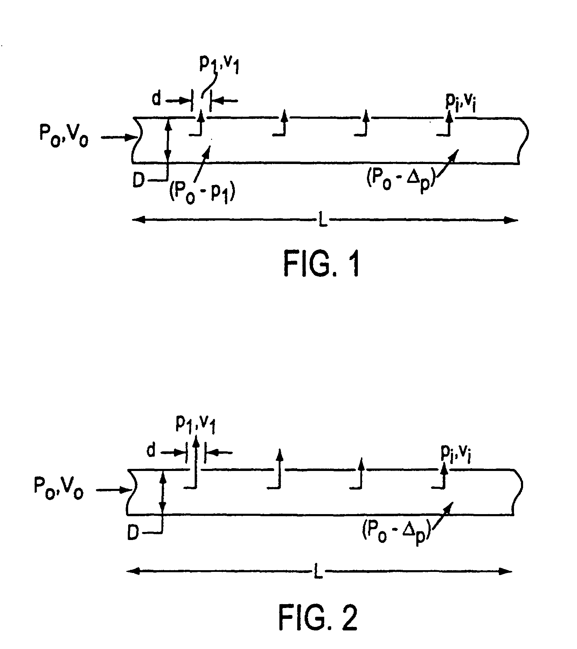

In the field of semiconductor fabrications, with device geometries shrinking to <0.2 micrometers comes the increasing demand for film deposition thickness nonuniformities of <2% range. The prior art for linear gas distribution systems has not been entirely successful in meeting these greater requirements. The simplest prior art design is a single tube with a distribution of holes or orifices along its surface as shown in Fig. 1, having a tube length of L and a diameter of D, with multiple orifices having diameter d. Gas is introduced at one end of the tube at a pressure $P_o$ and an initial velocity $V_o$. In this design, uniformity will typically be dependent on pressure. At each orifice, pressure and flow are reduced by some amount. Assuming the orifice sizes are small compared to the tube diameter D, and the supply pressure is adequately large, then the pressure and flow reduction per orifice are small compared to $P_o$ and $V_o$. Reduction in velocity along the tube is typically accompanied by an increase in pressure, except for small gas flows. At some distance far from the gas supply, the pressure in the tube $P_o$ will have dropped (as expressed by: $P_o - \Delta p$). With a single metering tube having orifices of the same diameter and equally spaced, uniform gas flow is not achieved. A particular shortcoming of the single tube prior art is the difficulty of providing good uniformity over increasing lengths needed to accommodate larger substrate sizes or diameters. For certain pressures, a given dimensional relationship between D, d, and L will result in somewhat uniform velocity vectors ($v_i$) and uniform gas flow by either redistributing these orifices of same given diameter or by varying the diameters of equally spaced holes. However, this distribution of orifices will result in optimum flow for a narrow range of operating conditions, if not just one particular operating condition. Moreover, such prior art design typically produce films having a high thickness nonuniformity of about 5 to 10%, depending upon the gas flow and pressure. Additionally, at low gas flows and low pressures, a higher flow of gas will emerge from the end nearest the supply as illustrated in Fig. 2. In other words, if $P_o$ is a relatively low value, the overall pressure in the tube drops more quickly as a function of the distance from the gas supply. The overall flow uniformity in this case will be very poor. In addition, gas flow from such tubes will tend toward increased directionality

**EP 1 054 311 B1**

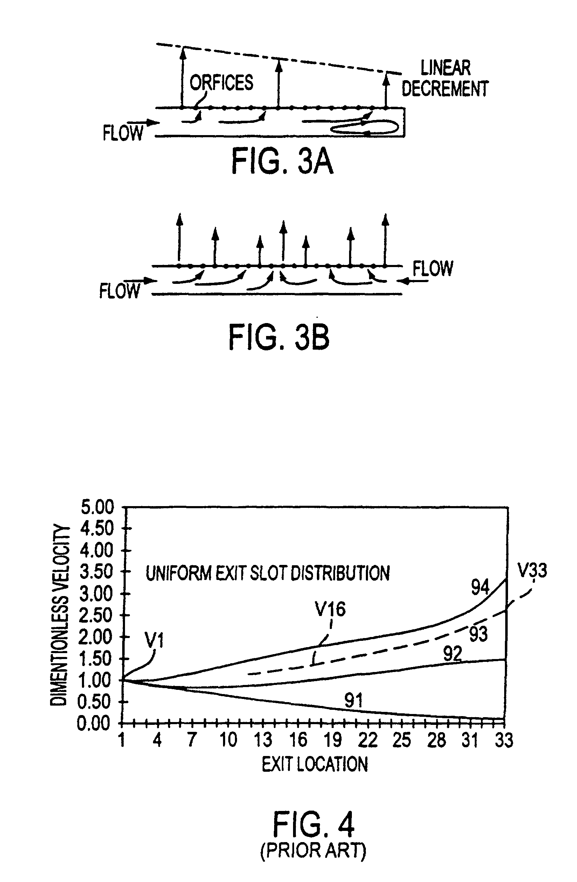

( also referred to as "jetting") as the supply flow and pressure increase. The gas flow out of the tube is nonuniform and exhibits linear decrement across its length as shown in Fig. 3a. Alternatively, gas may be introduced at each end of the tube as shown in Fig. 3b. In both cases the gas flow is not distributed uniformly which results in non-uniform deposition across the wafer.

An alternative prior art approach is the use of a single tube of porous material. Again, gas is introduced at one end of the tube. With this approach the "jetting" issue that accompanies a tube with holes is minimized. The porosity of the material will typically determine the achievable backing pressure within the tube, and hence also the overall uniformity along the length of the tube. For example, a screen mesh may be considered a porous material. For best uniformity, the mesh must offer good resistance to gas flow to maintain good backing pressure along the full length of the tube. Typically resistance to flow depends on the overall open area to tube surface area. Mesh openings are typically of the order of the thickness of the material or larger (> 0.005 inches). A second example is a porous ceramic having particle spacings on the order of micrometers (such materials are used often in filtration devices) and thicknesses on the order of millimeters. Such materials could offer resistance to gas flow to enable build up of uniform backing pressure, and good uniformity of delivered gas along the full length of the delivery line.

Though porous ceramic tubes can provide good uniformity of gas delivery, the material itself is quite fragile, and seals to the gas supply lines that can also withstand a wide range of temperatures are difficult to make.

A third alternative is to taper the tube diameter as a function of distance from the supply so that the fluid velocity is kept constant while the mass rate of flow decreases. The main drawback to this approach is that a design optimized for uniform flow at one flow rate will not work correctly at another flow rate.

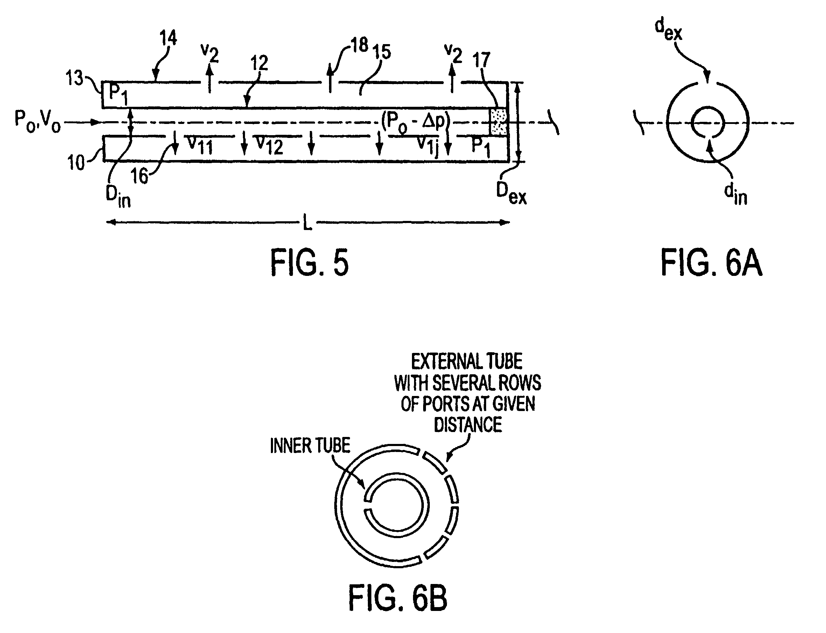

The biggest weakness of the prior art using single perforated or porous tubes is that they show relatively high sensitivity to changes in pressure, resulting in nonuniform flow as a function of position along the length of the delivery tube. Further, as shown in Fig. 4, non-uniform flow is a strong function of the gas flowrate, and as different applications and process conditions call for different gas flow rates, it becomes increasingly complicated to design and develop processes that provide uniform film deposition. The plots illustrated in Figure 4 represent a range of gas flow conditions and geometries typical of CVD applications, having Reynolds numbers $100 < R_c < 2000$. Moreover, as wafer diameters increase, the film non-uniformities are often exacerbated with increasing length of the gas delivery tube.

Changes in pressure may be imposed deliberately by a user, but often times occur due to fluctuations in the facilities gas delivery system to the CVD system. Thus, with the prior art, changes in gas pressure will influence the uniformity of gas delivery within the injector and/or deposition chamber, which then influences the resulting film uniformity or composition on the substrates. In other words, with prior art systems the gas delivery apparatus may be useful for only one operating condition. Accordingly, it is desirable to provide a gas delivery system that promotes substantially uniform flow and/or distribution of gases, particularly along a length which is impervious to fluctuations in the delivery system, and over a wide operational range of gas flows.

JP-A-61 037969 relates to an apparatus for producing thin films by plasma CVD.

It is an object of the present invention to provide an improved gas delivery metering tube for delivery of gases, and more particularly to provide substantially uniform gas delivery along the length of a gas delivery tube having gas supplied at one end. Accordingly, the present invention provides a gas delivery metering tube for delivery of gas, said metering tube comprising:

at least one innermost and outermost axially aligned, nested tubes having an effective annular space formed between said at least one innermost and outermost nested tubes,
one or more arrays of orifices formed in each of said at least one innermost and outermost nested tubes and extending along the substantial length of each of said tubes,

characterised in that said one or more arrays establish a substantially uniform backing pressure within and along the substantial length of the innermost tube, thereby promoting substantially uniform delivery of the gas out of the orifices in the outermost tube and along the substantial length of the outermost tube, and in that the innermost and outermost tubes have the following properties:

$D_{eff}$ and $D_{in}$ are within a factor of three of each other
$L/D_{in} < 70$
$D_{in}/d \approx> 10$
$Na_{port}/A_{tube} \approx\leq 1$
$Surface Area_{outer}/NA_{outer} \approx> 10$

where $D_{eff}$ is the effective diameter of the effective annular space, $D_{in}$ is the inner diameter of the innermost tube, L is the length of the innermost tube, d is the diameter of one orifice in said array of orifices in said innermost tube, N is the number of orifices in the innermost tube, $A_{port}$ is the cross sectional area of each of said orifices in the innermost

3

tube, $A_{tube}$ is the area of said innermost tube, Surface Area$_{outer}$ is the surface area of the outermost tube, and NA$_{outer}$ is the total cross sectional area of all of the orifices in the outermost tube. In another aspect of the invention, a gas delivery metering tube is provided in combination with at least one injector assembly having at least one port for receiving the gas delivery metering tube.

In yet another aspect of the invention, a gas delivery metering tube is provided in combination with a shield assembly having at least one plenum for receiving the gas delivery metering tube. The gas delivery metering tube is particularly suitable for use in semiconductor applications.

Other objects and advantages of the invention become apparent upon reading of the detailed description of the invention and the appended claims provided below, and upon reference to the drawings, provided by way of example, in which:

Figure 1 is a cross-sectional view of gas flows in a single tube used in the prior art.

Figure 2 is a cross-sectional view of gas flows in a single tube used in the prior art when the pressure is low.

Figure 3a and 3b are schematic representations of the gas flow non-uniformities of the prior art.

Figure 4 is a graph illustrating the gas flow distribution along the length of various types of tubes (prior art).

Figure 5 is a cross-sectional view of the gas delivery tube of the present invention.

Figures 6a and 6b are cross-sectional end views of the gas delivery tube according to two embodiments of the present invention.

Figure 7 is a cross sectional view of one example of a CVD deposition chamber showing a protective shield and an injector which may employ the gas delivery tube of the present invention.

Figure 8 is a cross sectional view of one example of an injector which may employ the gas delivery tube of the present invention.

Of particular advantage, the present invention provides a gas distribution tube that meters the gas distribution along a length, in particular the length of the tube, and makes the resulting gas distribution from the tube less sensitive to pressure changes over a wide range of operating conditions or gas flow ranges, and addresses the shortcomings of the prior art. The present invention consists, of a gas delivery tube having a tube assembly of two or more nested, axially aligned or coaxial tubes with the innermost tube preferably attached to a gas supply, and with both the inner and outer tubes having one or more arrays of orifices distributed along the lengths of the innermost and outermost tubes. For purposes of discussion, a gas delivery tube 10 comprised of two axially aligned, nested tubes having circular cross section shall be discussed, however other numbers of tubes can be used such as three nested or more coaxial tubes. The length of gas delivery tube to be used to process semiconductor substrates is typically several centimeters longer than the width or diameter of the substrate.

One embodiment of the invention is shown with reference to Figures 5 and 6a. Figure 5 is a schematic drawing of a gas delivery tube 10 comprised of a two tube assembly having coaxial inner 12 and outer 14 tubes separated by an annular space 15. Each tube has two ends. The inner tube 12 has one end 13 attached to the gas supply and the other end 17 is capped. One or more arrays of orifices 16 are distributed along the substantial length of the inner tube 12, and are positioned and sized to establish a uniform backing pressure along the full length of the inner tube 12, and still provide sufficient gas flow out of the inner tube 12 into the annular space 15. The outer tube 14 contains an array of orifices 18 distributed along its substantial length. The one or more arrays of orifices 18 are positioned and sized to maintain a uniform backing pressure within the annular space, and to provide uniform gas flow out ofthe outer tube 14 and into the area adjacent the outer tube 14. Preferably, the outer tube 14 is capped at both ends; however, in an alternative embodiment the outer tube may also receive a gas supply. Preferably, the line of inner orifices 16 are rotationally offset 180 degrees from the line array of outer orifices 18 as shown in Figure 5 and 6a. However, any rotational alignment and liner alignment between these arrays can be used. The preferred embodiment aligns the inner array of orifices 180° from the outer array of orifices.

While the gas delivery tube 10 has been described having two axially aligned nested tubes, additional tubes may be used. For example, the gas delivery tube 10 may be comprised of three, or more, coaxial tubes. Through the use of two or more nested coaxial tubes, the inventive apparatus reduces the sensitivity to pressure effects over a wide flow range by first establishing uniform backing pressure along the length of the inner tube, and then maintaining and transferring that uniformity and constancy of pressure to the annular space between the two tubes over the full length of the tube assembly 10. The resulting gas outflow from the outer tube can thus be quite uniform. The present invention thus effectively separates the establishment of pressure and flow over the length of the tube assembly into two steps.

As discussed above, the prior art having a single tube with an array of orifices and supplied by gas at one end requires that the gas backing pressure be equivalent over its full length to provide uniform flow out of the array of orifices. At low flow conditions, the backing pressure may fall too low, and flows from orifices furthest from the supply may drop resulting in nonuniform distribution over the length of the tube. In contrast, according to the present invention, the inner tube 12 of the present invention is sized in diameter and the array of orifices 16 to establish uniform backing pressure along its full length In other words, the relationship between the diameter of the tube and the diameter of the orifices is important. The orifices 16 are distributed along the substantial length, and preferably the full length, of the inner tube 12 and are sized and numbered to ensure sufficient resistance to gas flow outward from the inner tube to build backing pressure within the whole inner tube's length. Gas flow from the inner tube is evenly distributed along its length, and feeds the annular space between the inner and outer tubes.

In Mokhtari et al. ("*Flow Uniformity and Pressure Variation in Multi-Outlet Flow Distribution Pipes*," Advances in Analytical, Experimental and Computational Technologies in Fluids, Structures, Transients and Natural hazards, ASME, PVP - Volume 355, page 113, 1997) the general relationships among the inner diameter of the inner tube 12 ($D_{in}$), tube length L, and orifice size ($d_{in}$) for establishing uniform flow along a single tube, are discussed. Further, in Acrivos et al. ("*Flow Distribution in Manifolds*," Chemical Engineering Science, Vol. 10, pages 112 to 124, Pergamon Press 1959) requires that $L/D_{in} < 70$ while Mokhtari suggests by example that $L/D_{in} > 50$. In addition, Mokhtari et al show that $D_{in}/d_{in} = 10$ or more should expect to provide good flow uniformity over the full length of the tube. Acrivos suggests that the ratio of total orifice area ($N\pi d_{in}^2/4$) to area of the manifold ($\pi D_{in}^2/4$) should not exceed unity.

The prior art thus provide a set of rules to establish relatively stable backing pressure in a single tube. Specifically, the following relationships are shown: $L/D < 70$, $D/d \approx > 10$, and $Na_{port}/A_{tube} \approx 1$, where N is the number of orifices in the tube, and $a_{port}$ is the cross sectional area of each of these orifices. This prior art is limited to a single tube arrangement, however, and as discussed above such single tube arrangements are limited in their performance and do not provide satisfactory film uniformity.

The inventors have discovered that maintaining the prior art requirements for the inner tube 12 establishes relatively stable backing pressure ($P_o - \Delta p$) within the inner tube 12. Further, the inventors have discovered that maintaining substantially constant gas flow from the orifices 16 of the inner tube feeds into the annular space 15 between the two tubes, and provides substantially uniform gas flow over the full length of tubes. According to the present invention, the pressure uniformity in the annular space between the inner 12 and outer 14 tubes is established by the size of the annular space, and the uniformity of the gas distribution is governed by the distribution of the orifices 16 of the inner tube 12, but is substantially improved by the addition of an outer tube 14 and its orifices 18. Thus, according to the present invention the combination of at least two coaxial tubes establishes constant and uniform pressure within the annular space 15 between the innermost 12 and outermost 14 tubes and along the length of such tubes, resulting in distribution of gases from the outermost tube that can be very uniform.

The inventors have found that preferably the cross-sectional area of the annular space 15 between the inner 12 and outer 14 tubes to that of the inner tube 12 cross-sectional area should be approximately equivalent, but must be at least within a factor of three of each other. In other words, the effective diameter of the effective annular space $D_{eff}$, and the inner diameter of the innermost tube $D_{in}$ are within a factor of three of each other, and preferably $D_{eff} \approx D_{in}$. In addition, the ratio of inner surface area of a tube to the total cross-sectional area of all of the orifices in the tube should be equal to or greater than approximately 10 and preferably greater than 100. In other words, $SurfaceArea_{outer}/NA_{outer} \approx 10$ or more. This provides significantly improved gas flow non-uniformity values, i.e. equal to and less than about 3% range for the present invention as compared to about 5 to 10% obtained by the prior art. The sensitivity of the relationship between gas flow uniformity to the tube length is much less for the outer tube 14 than it is for the inner tube 12.

In summary, the inventive idea is to establish constant backing pressure along the length of the gas delivery tube through the design of the inner tube, and then to maintain a constant pressure and uniform distribution over the length through the geometric relationship of the inner and outer tubes, and finally to meter the gas flow through the outer tube's orifice distribution.

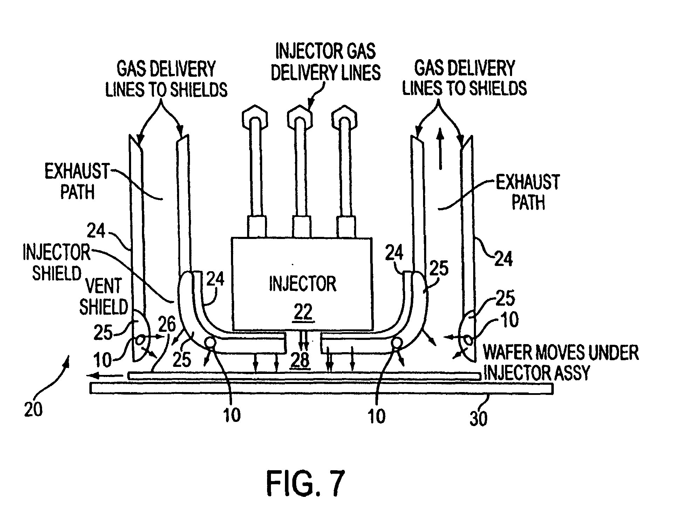

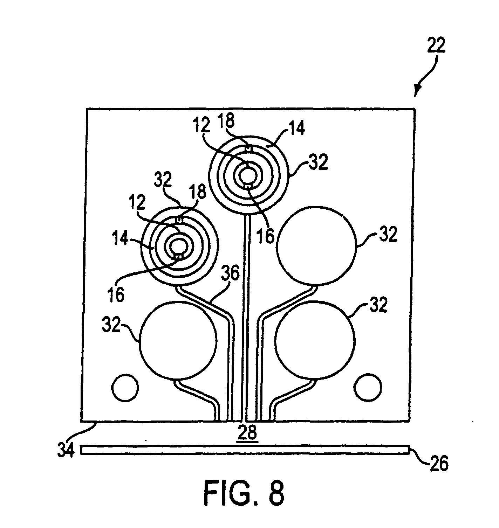

The present invention may be used in a vast number of applications. Two such applications are discussed below. In one embodiment, the gas delivery metering tube 10 of the present invention is employed with an atmospheric/subatmospheric chemical vapor deposition system using a linear injector arrangement, such as that illustrated in Figs. 7 or 8. The gas delivery metering tube 10 may be used within the injector itself (as shown in Figure 8) and/or within shields that flank the injector (as illustrated in Figure 7).

A portion of a CVD system 20 is shown in Fig. 7. The CVD system 20 includes a deposition chamber including an injector 22, protective shield assembly 24 and a wafer 26 which is transported by a transport mechanism 30 such as a belt underneath the injector 22 and shield assembly 24 and through a deposition region 28. Gases are injected into the deposition region 28 from the injector and react to deposit a layer or film on the surface of the wafer. The shield assembly 24 typically injects an inert gas, such as nitrogen, which aids in minimizing the build up of deposits on the injector surfaces and also acts to help isolate the deposition region 28. In this embodiment, the shield assembly 24 is comprised of four sections, two of which flank the injector 22. An example of this type of CVD system is further described in US Patent No. 5,849,088, and patent application Serial No. 09/185,180 (Attorney Docket No A-65583-1); the disclosures of both are hereby incorporated by reference in their entirety.

With industry requirements for film thickness non-uniformities of less than about 3% range, it is important for the shield gas flow flanking the injector to remain stable over time, and that gas flow on each side of the injector be well-defined along its own length and also be well-defined with respect to the gas flow on the side opposite the injector. Deposition gases are delivered perpendicularly onto a substrate's surface by the linear injector, with gases exhausted to either side of the injector. More specifically, the shield assembly's 24 primary purpose is to minimize deposition of unused material on the injector 22 and exhaust path surfaces. The shield assembly 24 consists of several sections with contoured surfaces of perforated material forming a plenum 25 therein through which an inert gas is delivered. The inert gas is delivered into the exhaust path and dilutes the unused deposition gas stream and also directs the unused deposition gases away from the exhaust path surfaces.

For maximum effectiveness, the inert gas must be delivered just downstream of the deposition area, and this proximity requires that the inert gas not perturb the distribution of deposition gases onto the wafer substrate. In addition, typical APCVD and SACVD tools require application of heat at the substrate to enable the deposition gases to react and recombine to form the desired films. The wafer temperature is typically $500°C$ or more, and thus the surrounding apparatus, though not directly heated, can also expected to be at elevated temperatures (several hundreds of degrees C). Thus, it is preferred for the inert gas to be metered and delivered at uniformities along the length of the shield and the injector which are similar to the uniformities required of the deposition gases (i.e. about< 1 %nonuniformity), and its hardware design must be capable of operation over a wide range of temperatures. Of particular advantage, the gas delivery tube 10 of the present invention is well suited for providing such metered gas flow over the full width of the shield assembly which spans the diameters or widths of the substrate, and this is particularly advantageous for large substrate diameter, such as 300 mm wafer. In particular, as shown in Fig. 7, a gas delivery tube 10 of the present invention may be located in the plenum 25 of one or more of the shield assembly sections. The gas delivery tube 10 may be positioned at any desired location within the shield assembly section, and more than one tube may be placed within each section.

Typically, the shield 24 and injector 22 are removed for cleaning with etchants such as hydrofluoric acid. Thus, it is preferable that the gas delivery tube 10 also tolerate such cleaning solutions and/or be easily removable to enable servicing of the shield assembly alone.

In another embodiment, the gas delivery tube 10 may be employed within the injector assembly 22 itself, preferably within a linear injector such as the type described in Patent No. 5,683,516 and patent application Serial no. 09/113,823 (Attorney Docket A-59471-4), the disclosures of which are both hereby incorporated by reference in their entirety. In general, the injector 22 consists of multiple cross channels, or ports 32, running the length of the injector 22, each of which are coupled to common gas delivery surface 34 by narrow slot like channels 36, which also extend the length of the injector 22. Gases exit the gas delivery surface 34 to the deposition region 28, (i.e. a volume) just above the wafer substrate 26. Preferably, the deposition gases are fed separately to each of the ports 32. The cited disclosures discuss in detail several configurations to ensure uniform distribution of the deposition gases along the full length of the injector 22. Of particular advantage the gas delivery tube 10 of the present invention is well suited as a gas delivery device that may be inserted into one or more of the plenums 32 of the injector 22 to provide desired uniform and/or metered gas flow.

Typically non-uniformities of the film thickness using the prior art are close to about 2% range, although this may vary upwards of 4% to 5% film thickness non-uniformity depending on the type of process chemistries used and the CVD conditions. The present invention provides improvements to the prior art through further improvement of the uniformity of gas distribution, resulting in film nonuniformities of equal to and less than about 2% range demonstrated, a substantial improvement over the prior art.

Of particular advantage, the present invention provides means to "meter" the gas flow to ensure substantially uniform distribution over the length of the gas delivery system. For the shield application, the gas flow rates are typically on the order of a few standard liters per minute (slm) to about 30 slm per tube, while for the injector application the gas flow rates are preferably on the order of a few slm to about 20 slm. In the shield application, the inert gas is delivered into a relatively unconfined volume behind the shield screen, while in the injector application, the cross proximity of the plenum and channel slot help to modulate the gas distribution and to direct the flow.

The geometry of the linear injector, shield and substrate arrangement requires that gas be introduced at one end of the delivery tube. Prior art for linear gas distribution systems includes several approaches that have not been successful in certain APCVD systems, particularly those for substrates that are ≥200 mm wide. The simplest type of design is a single tube with a distribution of orifices along its surface as shown in Figures 1 and 2 and discussed above.

For the case where the gas delivery metering tube of the present invention is used in the shield application, it is undesirable for the gas flow to "jet" from the inert gas delivery assembly, but rather should emerge azimuthally uniformly from the tube. For this case, according to an alternative embodiment of the present invention, the outer tube orifice distribution pattern may be several arrays or rows of small holes along the length of the tube and azimuthally distributed (Figure 6b).

For the case of the injector application illustrated in Fig. 8, the injector cross channel or port itself forms a boundary around the inventive assembly and can modulate the gas direction before it flows through the slot channels to the mixing chamber. Hence, the rules governing the outer tube orifice distribution pattern may be less restrictive in the injector application than that of the shield application, and may consist of a few rows and perhaps longer pitch along the tube length. Utilizing the gas delivery metering tube of the present invention promotes greater uniform gas flow in both the shield and injector applications. While two specific examples have been discussed, it should be understood that the gas delivery metering tube of the present invention may be employed alone and additionally is suitable in many applications where substantially uniform gas delivery is desirable, such as for example in all CVD applications, semiconductor equipment and the like.

Several examples are provided below for illustration purposes only, and are not intended to limit the invention. The parameters of the various examples are shown in Table 1:

Table 1

| | Inner Tube | | | | | Outer tube | | | | |
|---|---|---|---|---|---|---|---|---|---|---|
| Case | # rows | # holes per row | hole diz | ID | OD | # rows | # holes per row | hole dia | ID | OD |
| A | 1@ 2@ | 39 38 | 0.014 | 0.114 | 0.134 | 5 | 156 | 0.014 | 0.186 | 0.25 |
| B | 1 | 39 | 0.010 | 0.114 | 0.134 | 6 | 156 | 0.014 | 0.186 | 0.25 |
| C | porous | | | | | | | | | |
| D | 1 | 39 | 0.0095 | 0.136 | 0.156 | 1 | 77 | 0.0138 | 0.261 | 0.281 |
| E | 1 | 39 | 0.0095 | 0.136 | 0.156 | | 3 | 3.06 x .005 | 0.261 | 0.281 |

**Illustrative Examples:**

Example 1: The following demonstrates the viability of the design parameters shown in Case A of Table 1, used for a metering tube placed within a protective shield similar to that illustrated in Figure 7.

Backing pressure is approximately 200Torr
Gas Flow: 5 to 30 l/min per tube
Inner tube length (first hole to last hole) ≈ 9.26 inches
Outer tube length (first hole to last hole) ≈ 9.7 inches

The inner tube dimensions are shown in Table 1 (inner diameter, ID, equal to 0.114 inch, and outer diameter, OD, equal to 0.134 inch), while the outer tube dimensions are ID = 0.186 inch and OD = 0.250 inch.

The effective diameter, $D_{eff}$, for the annulus between inner and outer tubes can be determined by:

$$A_{outer} - A_{inner} = \pi \left(\frac{D_{eff}}{2}\right)^2 \tag{1}$$

where $A_{outer}$ is the cross-sectional area of the outer tube, $A_{inner}$ is the cross sectional area of the inner tube, having diameters $ID_{outer}$ and $OD_{inner}$, respectively, and $D_{eff}$ is the effective diameter of the annulus between the inner and outer tubes. Thus, solving Equation 3 for the conditions

$$2\left(\frac{A_{outer} - A_{inner}}{\pi}\right)^{1/2} = D_{eff} \tag{2}$$

$$2\left(R_{outer}^2 - R_{inner}^2\right)^{1/2} = D_{eff} \tag{3}$$

provided above yields:

$$= 2 \times [(.186/2)^2 - (.134/2)^2]^{1/2} = \underline{0.129 \text{ inches}} = D_{eff}$$

Of interest is a comparison between the cross sectional area of the tube and the sum of the cross sectional areas of the tube's orifices. For the inner tube, the cross sectional area is $\pi(ID_{inner}/2)^2 = \pi(.114/2)^2 = \underline{0.00325\pi}$, while each orifice's cross sectional area is $\pi(.007)^2 = \underline{0.000049\pi}$.

For the inner tube design we are interested in the value of three conditions as described in the prior art of Mohktari and Acrivos. The three conditions are (a) the ratio of the length of the tube to its diameter, (b) the ratio of the diameter of the tube to the port diameter, and (c) the ratio of the sum of all the orifice areas to the cross sectional area of the tube. Specifically:

$$L/D < 70 \tag{4a}$$

$$D/d \approx > 10 \tag{4b}$$

$$NA_{port}/A_{tube} \approx \leq 1 \tag{4c}$$

The values calculated above for the inner tube design in Case A of the Table 1 yield:

(a) Inner tube L/D = 9.26/0.114 = $\underline{81}$
(b) Inner tube D/d = 0.114/0.014 = $\underline{8.1}$
(c) The ratio of total number of orifices to cross sectional area inner tube:
39 x (0.000049)$\pi$/(0.00325$\pi$) = $\underline{0.6}$

Comparing the calculated values of the proposed design with the design guidelines of the prior art (Equations 4a, 4b, 4c) show that the proposed design for the inner tube of Case A approximately meets the conditions for uniform flow, and it is noted that the design results are on the high side of Condition 4a.

According to the present invention, the design criteria for the outer tube are:

$$D_{eff} \approx D_{in} \text{ (or at least within a factor of 3 of each other)} \tag{5a}$$

$$\text{Surface Area}_{outer}/NA_{outer} \approx 10 \text{ or more} \tag{5b}$$

where $D_{in}$ is the inner diameter of the innermost tube, SurfaceArea$_{outer}$ is the surface area of the outermost tube and NA$_{outer}$ is the total cross sectional area of all the orifices in the outermost tube.

The design values of Case A of Table 1 for the outer tube yield:

(a) $D_{eff}$=0.129 $\approx$ 0.114 = $D_{in}$
(b) Surface area to cross sectional port area = $(9.7)\pi(.186)/(156 \times 5 \times .007^2\pi)$ = 47 and the design criteria are thus met.

Example 2: The following demonstrates the viability of the design parameters shown in Case D of Table 1, used for a metering tube within an injector assembly (as illustrated in Figure 7).

Backing pressure is approximately 200 Torr.
Gas flow: 2 to 20 l/min per tube.
Inner tube length (first hole to last hole) $\approx$ 9.27 inches

The inner tube and outer tube inner/outer diameter dimensions are given in Case D of Table 1. The various key design values can be calculated using the equations and process described in Example 1 above. Specifically,

$D_{eff}$ for annulus between Inner and Outer tubes

$$= 2 \times [(.261/2)^2 - (.156/2)^2]^{1/2} = \underline{0.209 \text{ inches}} = D_{eff}$$

Cross sectional area of inner tube = $\pi(.136/2)^2$ = $\underline{0.00462\pi}$
Cross sectional area of inner and outer orifices = $\pi(.0048)^2$ = $\underline{0.000023\pi}$

Using this data, the relationships shown in 4a, 4b, 4c for the inner tube design of Case D may be computed as:

$$L/D_{in} = 9.27/.136 = \underline{68}$$

$$D_{in}/d = .136/.0095 = \underline{14.3}$$

$$Na_{port}/A_{tube} = 39\pi(.0048)^2/.00462\pi = \underline{0.19}$$

Comparing the calculated values of the proposed design with the design guidelines of the prior art show that the proposed design for the inner tube of Case D approximately meets the conditions for uniform flow.

The proposed outer tube design for Case D must also be verified against the criteria of Equations 5a and 5b. For Case D, the first relationship is met; that is, $\frac{D_{eff}}{D_{in}}$ = .209/.136 = 1.54 which is well within the required factor of 3. The outer tube of Case D is comprised of 77 holes each having a diameter of 0.0138 inches. Thus, Equation 5b for an outer tube approximately 9.7 inch long becomes, $9.7\pi(.261)/(77 \times .0069^2\pi)$ = 690.

Example 3: Case E of Table 1 uses the same inner tube design as Case D but has a set of three narrow slots rather than a linear array of orifices in the outer tube. The relationships for the outer tube with such a set of slots according to the present invention are thus:

$$\frac{D_{eff}}{D_{in}} = .209/.136 = 1.54$$

as before

Surface area to cross sectional slot area =

$$(9.7)\pi(.261)/(3 \times 3.060 \times .005) = 173$$

and again the criteria for the outer tube are met.

The annular space between the innermost and outermost tubes is an effective annular space. In other words the annular space is the area between the innermost and outermost tubes irrespective of the shape of the tubes since the tubes can be of a variety of shapes (in addition to a cylindrical shape).

As described above and demonstrated by the aforementioned experiments, the gas delivery metering tube of the present invention provides substantially uniform gas flow along a given length, irrespective of diameter size or length, by creating a means to establish constant backing pressure independently from establishing uniform flow along the tube length. As shown, the annular cross sectional volume is important to achieving the desired flow rate and uniformity. Of particular advantage, it is found that the wall size of the tubes is not important in achieving the desired result, provided that the aspect ratio (i.e. the hole-to-wall thickness) is ≥1; nor is the supply gas feed, provided the supply gas feed does not constrict the gas flow.

Of further advantage, the axially aligned, nested tubes can be of different shapes. For example, the nested tubes can be comprised of two axially aligned, rectangular tubes, as opposed to the cylindrical tubes shown in the figures. Moreover, the gas delivery metering tubes of the present invention can be configured to provide the "jetting" type gas flow when desired, or alternatively can be configured for the absence of jetting.

Other features and advantages of the present invention may be apparent to a person of skill in the art who studies the present invention disclosure. The foregoing description of specific embodiments and examples of the invention have been presented for the purpose of illustration and description, and although the invention has been illustrated by certain of the preceding examples, it is not to be construed as being limited thereby. They are not intended to be exhaustive or to limit the invention to the precise forms disclosed, and obviously many modifications, embodiments, and variations are possible in light of the above teaching.

**Claims**

1. A gas delivery metering tube for delivery of gas, said metering tube (10) comprising:

   at least one innermost (12) and outermost (14) axially aligned, nested tubes having an effective annular space (15) formed between said at least one innermost (12) and outermost (14) nested tubes,
   one or more arrays of orifices (16,18) formed in each of said at least one innermost (12) and outermost (14) nested tubes and extending along the substantial length of each of said tubes (12,14),

   **characterised in that** said one or more arrays (16,18) establish a substantially uniform backing pressure within and along the substantial length of the innermost tube (12), thereby promoting substantially uniform delivery of the gas out of the orifices (18) in the outermost tube (14) and along the substantial length of the outermost tube (14), and **in that** the innermost (12) and outermost (14) tubes have the following properties:

   $D_{eff}$ and $D_{in}$ are within a factor of three of each other
   $L/D_{in} < 70$
   $D_{in}/d \approx> 10$
   $Na_{port}/A_{tube} \approx\leq 1$
   Surface $Area_{outer}/NA_{outer} \approx> 10$

   where $D_{eff}$ is the effective diameter of the effective annular space (15), $D_{in}$ is the inner diameter of the innermost tube (12), L is the length of the innermost tube (12), d is the diameter of one orifice in said array of orifices (16) in said innermost tube (12), N is the number of orifices (16) in the innermost tube (12), $A_{port}$ is the cross sectional area of each of said orifices (16) in the innermost tube (12), $A_{tube}$ is the area of said innermost tube (12), Surface $Area_{outer}$ is the surface area of the outermost tube (14), and $NA_{outer}$ is the total cross sectional area of all of the orifices (18) in the outermost tube (14).

2. A gas delivery metering tube as claimed in claim 1, wherein $D_{eff}$ is approximately equal to $D_{in}$.

3. A gas delivery metering tube as claimed in claim 1 or claim 2, wherein Surface $Area_{outer}/NA_{outer} > 100$.

4. A gas delivery metering tube as claimed in any one of claims 1 to 3, wherein said metering tube (10) is used in a chemical vapor deposition system (20).

5. A gas delivery metering tube as claimed in any one of claims 1 to 4, wherein the nested tubes (12,14) are cylindrical, or rectangular in shape.

6. A combination of a gas delivery metering tube as defined in any one of claims 1 to 5 in combination with at least one injector assembly (22) having at least one port for receiving said gas delivery metering tube (10).

7. A combination of a gas delivery metering tube as defined in any one of claims 1 to 5 in combination with at least one shield assembly (24) having at least one plenum for receiving said gas delivery tube (10).


**Patentansprüche**

1. Gasabgabe-Messrohr zum Abgeben von Gas, wobei das Messrohr (10) umfasst:

   zumindest ein innerstes (12) und ein äußerstes (14) Rohr, die axial fluchten und ineinander geschoben sind, wobei zwischen dem zumindest einen innersten und einen äußersten (14) ineinander geschobenen Rohren ein tatsächlicher ringförmiger Raum (15) gebildet wird,

   eine oder mehrere Anordnungen von Öffnungen (16, 18), die in jedem aus dem zumindest einen innersten (12) und einen äußersten (14) ineinander geschobenen Rohren gebildet sind und sich entlang der substantiellen Länge eines jeden der Rohre (12, 14) erstrecken,

   **dadurch gekennzeichnet, dass** die eine oder die mehreren Anordnung(en) (16, 18) ein im Wesentlichen gleichmäßiges Vorvakuum innerhalb und entlang der substantiellen Länge des innersten Rohres (12) erzeugen, wodurch die im Wesentlichen gleichmäßige Abgabe des Gases aus den Öffnungen (18) im äußersten Rohr (14) und entlang der substantiellen Länge des äußersten Rohres (14) gefördert wird und dass das innerste (12) und das äußerste (14) Rohr die folgenden Eigenschaften aufweisen:

$D_{eff}$ und $D_{in}$ liegen innerhalb eines Faktors 3 zueinander
$L/D_{in} < 70$
$D_{in}/d \approx > 10$
$Na_{port}/A_{Rohr} \approx \leq 1$
$Oberfläche_{außen}/NA_{außen} \approx > 10$

worin $D_{eff}$ der tatsächliche Durchmesser des tatsächlichen ringförmigen Raums (15) ist, $D_{in}$ der Innendurchmesser des innersten Rohres (12) ist, L die Länge des innersten Rohres (12) ist, d der Durchmesser einer Öffnung in der Anordnung von Öffnungen (16) im innersten Rohr (12) ist, N die Anzahl der Öffnungen (16) im innersten Rohr (12) ist, $A_{port}$ die Querschnittsfläche einer jeden der Öffnungen (16) im innersten Rohr (12) ist, $A_{Rohr}$ die Fläche des innersten Rohres (12) ist, $Oberfläche_{außen}$ die Oberfläche des äußersten Rohres (14) ist und $NA_{außen}$ die Gesamt-Querschnittsfläche aller Öffnungen (18) im äußersten Rohr (14) ist.

**2.** Gasabgabe-Messrohr nach Anspruch 1, worin $D_{eff}$ etwa gleich $D_{in}$ ist.

**3.** Gasabgabe-Messrohr nach Anspruch 1 oder 2, worin $Oberfläche_{außen}/NA_{außen} > 100$ ist.

**4.** Gasabgabe-Messrohr nach einem der Ansprüche 1 bis 3, worin das Messrohr (10) in einem chemischen Dampfabscheidungssystem (20) verwendet wird.

**5.** Gasabgabe-Messrohr nach einem der Ansprüche 1 bis 4, worin die ineinander geschobenen Rohre (12, 14) zylindrische oder rechteckige Gestalt aufweisen.

**6.** Kombination aus einem Gasabgabe-Messrohr nach einem der Ansprüche 1 bis 5 in Kombination mit zumindest einer Einspritzungsanordnung (22), die zumindest eine Öffnung zum Aufnehmen des Gasabgabe-Messrohres (10) aufweist.

**7.** Kombination aus einem Gasabgabe-Messrohr nach einem der Ansprüche 1 bis 5 in Kombination mit zumindest einer Abschirmungsanordnung (24), die zumindest eine Kammer zum Aufnehmen des Gasabgaberohres (10) aufweist.

**Revendications**

**1.** Tube doseur de fourniture de gaz pour la fourniture de gaz, ledit tube doseur (10) comprenant :

au moins un tube le plus intérieur (12) et un tube le plus extérieur (14) emboîtés, alignés axialement, ayant un espace annulaire effectif (15) formé entre lesdits au moins un tube le plus intérieur (12) et un tube le plus extérieur (14) emboîtés,
une ou plusieurs rangées d'orifices (16, 18) ménagés dans chacun desdits au moins un tube le plus intérieur (12) et un tube le plus extérieur (14) emboîtés et s'étendant sur sensiblement la longueur de chacun desdits tubes (12, 14),

**caractérisé en ce que** une ou plusieurs rangées précitées (16, 18) établissent un prévide sensiblement uniforme dans et sur sensiblement toute la longueur du tube le plus interne (12) en encourageant ainsi une fourniture sensiblement uniforme du gaz hors des orifices (18) dans le tube le plus externe (14) et sur sensiblement toute la longueur du tube le plus externe (14), et **en ce que** le tube le plus interne (12) et le plus externe (14) ont les propriétés suivantes :

$D_{eff}$ et $D_{in}$ se situent dans un facteur de trois l'un relativement à l'autre
$L/D_{in} < 70$
$D_{in}/d \approx > 10$
$Na_{port}/A_{tube} \approx \leq 1$
$Aire\ de\ surface_{externe}/Na_{externe} \approx > 10$

où $D_{eff}$ représente le diamètre effectif de l'espace annulaire effectif (15), $D_{in}$ représente le diamètre interne du tube le plus interne (12), L est la longueur du tube le plus interne (12), d est le diamètre d'un orifice dans ladite rangée d'orifices (16) dans ledit tube le plus interne (12), N est le nombre d'orifices (16) dans le tube le plus interne (12), $A_{port}$ représente la zone en section transversale de chacun desdits orifices (16) dans le tube le plus interne (12), $A_{tube}$ est la zone dudit tube le plus interne (12), Aire de surface$_{externe}$ représente l'aire de surface du tube le plus externe (14) et $NA_{externe}$ est la zone en section transversale totale de tous les orifices (18) dans le tube le plus externe (14).

2. Tube doseur pour la fourniture de gaz selon la revendication 1, où $D_{eff}$ est approximativement égal à $D_{in}$.

3. Tube doseur pour la fourniture de gaz selon la revendication 1 ou la revendication 2, où l'aire de surface$_{externe}$/ $NA_{externe}$ > 100.

4. Tube doseur pour la fourniture de gaz selon l'une des revendications 1 à 3, où ledit tube de dosage (10) est utilisé dans un système de dépôt de vapeur chimique (20).

5. Tube de dosage pour la fourniture de gaz selon l'une des revendications 1 à 4, où les tubes emboîtés (12, 14) sont d'une forme cylindrique, ou rectangulaire.

6. Combinaison d'un tube doseur pour la fourniture de gaz selon l'une des revendications 1 à 5 en combinaison avec au moins un ensemble d'injection (22) ayant au moins un orifice pour recevoir ledit tube doseur de fourniture de gaz (10).

7. Combinaison d'un tube doseur pour la fourniture de gaz telle que définie dans l'une des revendications 1 à 5, en combinaison avec au moins un ensemble de protection (24) ayant au moins un collecteur pour recevoir ledit tube de fourniture de gaz (10).

FIG. 1

FIG. 2

FIG. 3A

FIG. 3B

FIG. 4
(PRIOR ART)

FIG. 6A

FIG. 5

FIG. 6B

EXTERNAL TUBE WITH SEVERAL ROWS OF PORTS AT GIVEN DISTANCE

INNER TUBE

FIG. 7

FIG. 8